# EUROPEAN PATENT SPECIFICATION

(11) **EP 0 342 737 B1**
(45) Date of publication and mention of the grant of the patent: **29.12.1993**
(21) Application number: 89201182.6
(22) Date of filing: 10.05.1989
(51) Int. Cl.: G03F 7/26

(54) **Method of manufacturing a semi-conductor device**
Verfahren zur Herstellung einer Halbleitervorrichtung
Procédé pour la fabrication d'un dispositif semi-conducteur

(30) Priority: 16.05.1988 NL 8801255
(43) Date of publication of application: 23.11.1989
(73) Proprietor: Philips Electronics N.V., 5621 BA Eindhoven (NL)
(72) Inventor: Schellekens, Jacobus Petrus Wilhelmus, NL-5656 AA Eindhoven (NL); Visser, Robert Jan, NL-5656 AA Eindhoven (NL)
(74) Representative: Stolk, Steven Adolph

(56) References cited:
- EP-A- 0 187 421
- EP-A- 0 198 215
- EP-A- 0 248 779
- EP-A- 0 291 670
- PATENT ABSTRACTS OF JAPAN, vol. 7, no. 23 (P-171)[1168], 29th January 1983 & JP-A-57 176 040 (TOKYO SHIBAURA DENKI K.K.) 29-10-1982
- PATENT ABSTRACTS OF JAPAN, vol. 7, no. 17 (E-154)[1162], 22nd January 1983 & JP-A-57 173 943 (TOKYO SHIBAURA DENKI K.K.) 26-10-1982

## Description

The invention relates to a method of manufacturing a semiconductor device, in which a layer of a radiation-sensitive material is provided on a substrate, which layer is irradiated in accordance with a pattern, after which the layer is treated using a gaseous organosilicon compound causing a silylation reaction to take place in accordance with a desired pattern, after which the layer is developed by means of a plasma.

Such a method is described in European Patent Application EP-A-184567, in which a mixture of a novolak and a diazonaphtoquinone compound is described as an example of a radiation-sensitive material (resist). The selectivity of the silylation reaction, which is carried out by means of a gaseous organosilicon compound, is based on an increased permeability in the irradiated areas. As a consequence of a reaction of the organosilicon compound with phenolic hydroxyl groups, silicon-containing organic groups are incorporated in the novolak polymer. On developing the resist material in an oxygen-containing plasma a layer of silicon oxide is formed which protects the underlying layers against etching. Consequently, the areas which are irradiated in accordance with a pattern are not etched (negative process).

A disadvantage of the known method is that the phenolic hydroxyl groups which are subjected to silylation are present both in the exposed and the unexposed areas. The selectivity is relatively low because it is based only on a difference in velocity caused by the raised permeability in the irradiated areas.

It is an object of the invention to provide a method of manufacturing a semiconductor device as described in the opening paragraph, having an improved selectivity (better contrast) so that also small details can be etched accurately, i.e. a high resolution.

This object is achieved in accordance with the invention by a method as described in the opening paragraph which is further characterized by an improved selectivity of the silylation reaction because ammonia or vapourous amine from an external source is added to the organosilicon compound. Surprisingly it has been found that the said addition substantially enhances the incorporation of silicon-containing organic groups in exposed areas, whereas in the unexposed areas the incorporation remains small. Owing to the improved selectivity an improved pattern definition or resolution is obtained.

The silylation reaction can be carried out using hexamethyl disilazane (HMDS), trimethyl silyl dimethylamine, tetrachlorosilane, trimethylchlorosilane or one or more of the organosilicon compounds mentioned for this purpose in European Patent Application EP 184567.

An embodiment of the method in accordance with the invention is characterized in that dimethylamine is used as an amine. Also other amines can be used provided that the vapour pressure of the amine used is such under the process conditions that the desired effect is obtained. Suitable amines are, for example, monomethylamine, trimethylamine, monoethylamine and diethylamine.

It has been found that the percentage by volume of ammonia or amine during the silylation reaction is not critical.

In a suitable embodiment of the method in accordance with the invention the radiation-sensitive material comprises novolak and a diazonaphtoquinone compound.

In another embodiment of the method in accordance with the invention the radiation-sensitive material comprises polyhydroxy styrene (polyvinyl phenol) and a diazonaphtoquinone compound.

It is remarked that EP-A-291670, which is prior art according to Art. 54 (3) EPC, discloses a silylation material that produces a strong base (such as dimethylamine) upon reaction with the resist Film. As an example N,N-dimethylaminotrimethylsilane is disclosed as a silylation material.

Patent Abstracts of Japan, Vol. 7, No. 17 (E-154)(1162), 22.01.1983, discloses that a resist pattern is made by a development process, after which the pattern is treated with a gas plasma of ammonia. Thereafter chemical etching is carried out using the treated resist pattern as a protective film.

Patent Abstracts of Japan, Vol. 7, No. 23 (P-171)(1168), 29.01.1983, discloses the etching with a solution of an amine or an organic ammonium salt solution after a resist layer has been patterned.

The invention will now be explained in greater detail by means of exemplary embodiments and with reference to drawings, in which
Fig. 1a-c schematically shows a number of steps of a method in accordance with the invention,
Fig. 2 is the structural formula of the repeating unit of a novolak polymer, wherein n has a value between 6 and 100,
Fig. 3 is the structural formula of the repeating unit of polyparahydroxy styrene (polyparavinyl phenol), wherein n has a value between 200 and 600,
Fig. 4 is the structural formula of a diazonaphtoquinone compound,
Fig. 5 is the structural formula of hexamethyl disilazane (HMDS),
Fig. 6 is the structural formula of a benzophenone compound.

### Example 1:

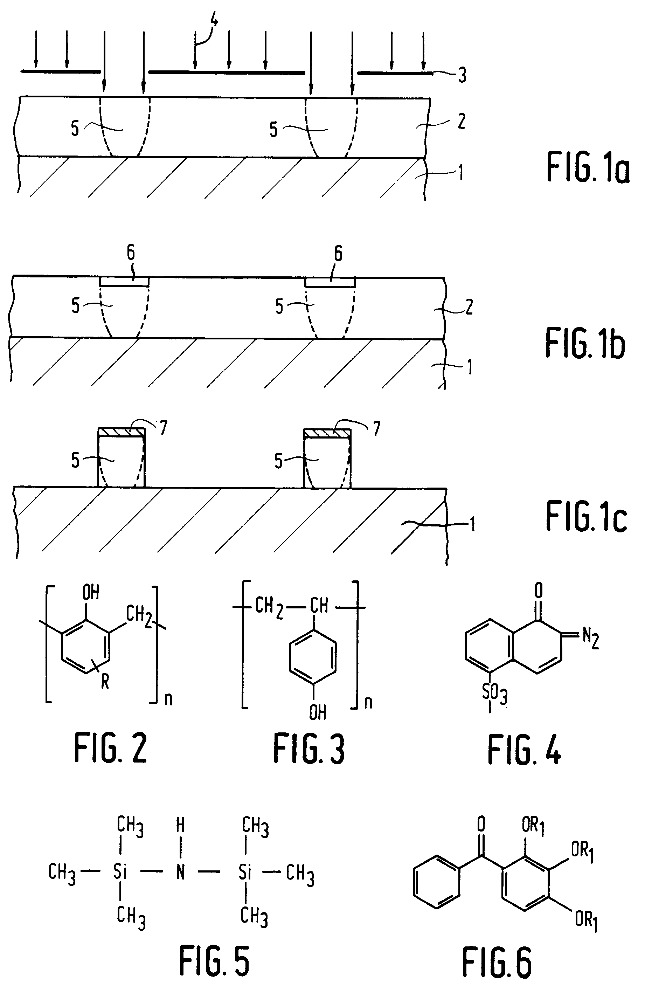

Fig. 1a shows a silicon wafer 1 which is covered by means of spinning with a radiation-sensitive layer 2 having a thickness of 1.7 µm. In accordance with this example, the resist material Plasmask which is marketed by the firm of UCB is used. This material contains a novolak polymer, see Fig. 2, wherein n is approximately 75 and the group R is an alkyl group, and a triester of a benzophenone compound as a radiation-sensitive component, see Fig. 6, to which three diazonaphtoquinone molecules R₁, see Fig. 4, are coupled. After the spin-coating of this material the layer is kept at a temperature of 90^{°} C in an air circulation oven for 30 minutes. The method in accordance with the invention can also be used, for example, in a bilevel system in which the radiation-sensitive layer is not directly applied to a silicon substrate but to another polymer layer, for example, a planarization layer.

The resist material is irradiated through a mask 3 by a high-pressure mercury discharge lamp (total dose approximately 150 mJ/cm², wavelength 300-500 nm). The radiation is indicated by arrows 4. In this way areas 5 are formed which are irradiated in accordance with a pattern.

Subsequently, the layer is heated to a temperature of 140° C in the reactor. After evacuation to a pressure of 10⁻³ Pa the silylation step is carried out, see Fig. 1b, by leading hexamethyl disilazane (HMDS, Fig. 5) from a liquid reservoir into the reactor until a pressure of 1842 Pa (= saturated vapour pressure of HMDS) is obtained. Subsequently, ammonia gas is introduced into the reactor until a total pressure of 2148 Pa (then the partial pressure of ammonia gas is 306 Pa) is obtained. Silicon-containing molecular groups are incorporated at the locations 6 of the radiation-sensitive layer.

Fig. 1c shows the result after developing using an oxygen plasma in a parallel-plate reactive ion etching device. The silicon-containing material is converted into a layer of silicon oxide 7 which protects the underlying material against etching. In plasma etching no underetching takes place.

The selectivity between the unexposed and the exposed parts of the resist is measured by measuring the infrared absorption at 918 cm⁻¹ after the silylation reaction. This frequency corresponds to the absorption band of the phenyl-oxygen-silicon bond. The absorption measured is directly proportional to the quantity of silicon incorporated in the radiation-sensitive layer. The absorption is measured after 30 minutes of silylation which is preceded by an exposure dose of approximately 150 mJ/cm². The absorption is also measured on an unexposed part of the resist, also after a silylation time of 30 minutes. The selectivity is the quotient of the absorption of the exposed and the unexposed part of the resist.
The results of the measurements on the silylated novolak are listed in column 1 of Table 1.

**Table 1**

| with ammonia | | without ammonia |
|---|---|---|
| IR-absorption exposed part | 0.252 | 0.151 |
| IR-absorption unexposed part | 0.008 | 0.007 |
| selectivity | 31 | 21 |

An analogous experiment is carried out by way of comparative example, with this difference that during the silylation reaction no ammonia is added. The results of this comparative example are listed in column II of Tabel 1. Table 1 shows that the addition of ammonia during the silylation reaction improves the selectivity with approximately 50%.

### Example 2:

In the same way as described in example 1, a silicon wafer is covered with resist material Shipley N42306. This material contains polyhydroxy styrene (polyvinyl phenol), see Fig. 3, wherein n has a value of approximately 400, and a triester of a benzophenone compound as a radiation-sensitive component, see Fig. 6, to which three diazonaphtoquinone molecules R₁, see Fig. 4, are coupled. Subsequently, this polymer layer is subjected to the same treatments as described in example 1. An analogous experiment is carried out by way of comparative example, with this difference that during the silylation reaction no ammonia is added. The results of the IR-absorption measurements on the silylated polyhydroxy styrene are listed in Table 2.

**Table 2**

| with ammonia | | without ammonia |
|---|---|---|
| IR-absorption exposed part | 0.431 | 0.040 |
| IR-absorption unexposed part | 0.013 | 0.013 |
| selectivity | 32 | 3 |

Table 2 shows that in the case of polyhydroxy styrene the selectivity improvement owing to the addition of ammonia during the silylation reaction is even larger than in the case of novolak, i.e. approximately a factor of 10. If no ammonia is added the selectivity of the silylation reaction is unsatisfactory when this resist is used.

### Example 3:

Example 1 is repeated, with this difference that dimethylamine (DMA) is introduced into the reactor instead of ammonia gas. The exposure dose is approximately 150 mJ/cm² and the silylation time is 20 minutes.

The results of the IR-absorption measurements on the silylated novolak are listed in column I of Table 3.

**Table 3**

| with DMA | | without DMA | with ammonia |
|---|---|---|---|
| IR-absorption exposed part | 0.227 | 0.145 | 0.226 |
| IR-absorption unexposed part | 0.007 | 0.007 | 0.007 |
| selectivity | 32 | 21 | 32 |

By way of comparative example an analogous experiment is carried out, with this difference that during the silylation reaction no DMA is added. The results of this comparative example are listed in column II of Table 3. Table 3 shows that the addition of DMA during the silylation reaction leads to an improvement of the selectivity with approximately 50%.

In a second comparative example, under the same conditions, DMA is replaced by ammonia gas. The results of this experiment are listed in column III of Table 3. Also in this case the selectivity is improved with approximately 50%.

It has been found that the method in accordance with the invention permits semiconductor devices having a high resolution to be manufactured very accurately, the formation of tracks in accordance with a descired pattern having a width of 0.4 µm being possible.

## Claims

1. A method of manufacturing a semiconductor device, in which a layer of a radiation-sensitive material is provided on a substrate, which layer is irradiated in accordance with a pattern, after which the layer is treated with a gaseous organosilicon compound such that a silylation reaction takes place in accordance with a desired pattern, after which the layer is developed using a plasma, characterized in that the selectivity of the silylation reaction is increased by adding from an external source ammonia or vapourous amine to the organosilicon compound.

2. A method as claimed in Claim 1, characterized in that dimethylamine is used as an amine.

3. A method as claimed in Claim 1 or 2, characterized in that the radiation-sensitive material comprises novolak and a diazonaphtoquinone compound.

4. A method as claimed in Claim 1 or 2, characterized in that the radiation-sensitive material comprises polyhydroxy styrene and a diazonaphtoquinone compound.

## Patentansprüche

1. Verfahren zur Herstellung einer Halbleiteranordnung, wobei auf einem Träger eine Schicht aus einem strahlungsempfindlichen Material angebracht wird, wobei diese Schicht mustermäßig bestrahlt wird, wonach sie mit einer gasartigen Organosillzium-Verbindung behandelt wird, wodurch in einem gewünschten Muster eine Silylationsreaktion stattfindet, wonach die Schicht mit einem Plasma entwickelt wird, dadurch gekennzeichnet, daß die Selektivität der Silylationsreaktion dadurch verbessert wird, daß Ammoniak oder dampfförmiges Amin von einer äußeren Quelle der Organosilizium-Verbindung hinzugefügt wird.

2. Verfahren nach Anspruch 1, dadurch gekennzeichnet, daß Dimethylamin als Amin verwendet wird.

3. Verfahren nach Anspruch 1 oder 2, dadurch gekennzeichnet, daß das strahlungsempfindliche Material Novolak und eine Diazohaphthochinonverbindung aufweist.

4. Verfahren nach Anspruch 1 oder 2, dadurch gekennzeichnet, daß das strahlungsempfindliche Material Polyhydroxystyrol und eine Diazonaphthochinonverbindung aufweist.

## Revendications

1. Procédé de fabrication d'un dispositif semi-conducteur, dans lequel une couche d'une matière sensible au rayonnement est disposée sur un substrat, laquelle couche est irradiée suivant un motif, après quoi la couche est traitée par un composé organosiliceux gazeux, de sorte qu'une réaction de silylation soit réalisée suivant un motif désiré, après quoi la couche est développée par un plasma, caractérisé en ce que la sélectivité de la réaction de silylation soit augmentée par addition, à partir d'une source extérieure, d'ammoniac ou d'une amine vaporisée au composé organosiliceux.

2. Procédé suivant la revendication 1, caractérisé en ce que la diméthylamine est utilisée comme amine.

3. Procédé suivant la revendication 1 ou 2, caractérisé en ce que la matière sensible au rayonnement comprend de la Novolaque et un composé diazonaphtoquinonique.

4. Procédé suivant la revendication 1 ou 2, caractérisé en ce que la matière sensible au rayonnement comprend un polyhydroxystyrène et un composé diazonaphtoquinonique.
